# EUROPÄISCHE PATENTSCHRIFT

(11) **EP 2 340 696 B1**
(45) Veröffentlichungstag und Bekanntmachung des Hinweises auf die Patenterteilung: **17.05.2017**
(21) Anmeldenummer: 09777911.0
(22) Anmeldetag: 17.08.2009
(51) Int. Cl.: H05K 5/02, G07C 9/00, F16P 3/00, G05B 19/042, G05B 19/04

(54) **DATENTRÄGER**
DATA CARRIER
SUPPORT DE DONNÉES

(30) Priorität: 12.09.2008 DE 102008047514
(43) Veröffentlichungstag der Anmeldung: 06.07.2011
(73) Patentinhaber: Pilz GmbH & Co. KG, 73760 Ostfildern (DE)
(72) Erfinder: DICKHOFF, Rolf, 73230 Kirchheim (DE); RINK, Joachim, 73732 Esslingen (DE)
(74) Vertreter: Witte, Weller & Partner Patentanwälte mbB
(86) Internationale Anmeldenummer: PCT/EP2009/005939
(87) Internationale Veröffentlichungsnummer: WO 2010/028734

(56) Entgegenhaltungen:
- EP-A1- 2 009 523
- DE-A1-102004 020 994
- DE-A1-102006 019 142
- DE-U1- 9 103 374
- DE-U1-202004 006 171
- US-A1- 2003 150 920
- US-A1- 2007 143 543

## Beschreibung

Die vorliegende Erfindung betrifft eine Sicherheitssteuerung zum Steuern von Maschinen oder Anlagen, von denen im Betrieb eine Gefahr für Menschen oder materielle Güter ausgeht, mit einer Ein-/Ausgabeeinheit zum Aufnahmen von Eingangssignalen von externen Sensoren und zum Ausgeben von Ausgangssignalen an externe Aktuatoren, mit einer Aufnahmeeinheit für einen Datenträger mit einem Trägerelement, welches ein Speicherelement trägt, wobei in dem Speicherelement Daten für die Sicherheitssteuerung abgelegt sind, wobei das Speicherelement ein Transponder zur berührungslosen Datenübertragung oder eine Speicherkarte mit Kontakten ist, und mit einer Übertragungseinheit zum berührungslosen Datenaustausch mit dem Transponder oder einer Kontaktiereinheit zum Kontaktieren der Kontakte auf der Speicherkarte.

Ein Sicherheitssteuerung der genannten Art ist aus der EP 2 009 523 A1 bekannt.

Das Dokument DE 10 2004 020994 A1 betrifft ein Verfahren und eine Vorrichtung zum Programmieren einer Sicherheitssteuerung sowie eine Sicherheitssteuerung nach dem Oberbegriff von Anspruch 1

Eine Sicherheitssteuerung im Sinne der vorliegenden Erfindung ist ein Gerät oder eine Vorrichtung, das bzw. die von Sensoren gelieferte Eingangssignale aufnimmt und daraus durch logische Verknüpfungen und unter Umständen weiterer Signal-oder Datenverarbeitungsschritte Ausgangssignale erzeugt. Die Ausgangssignale können dann Aktuatoren zugeführt werden, die dann in Abhängigkeit von den Eingangssignalen gezielte Aktionen oder Reaktionen in der Umgebung bewirken. Ein bevorzugtes Anwendungsgebiet für derartige Sicherheitssteuerungen ist im Bereich der Maschinensicherheit die Überwachung von Not-Aus-Tastern, Zwei-Hand-Steuerungen, Schutztüren oder Lichtgittern. Derartige Sensoren werden verwendet, um bspw. eine Maschine, von der im Betrieb eine Gefahr für Menschen oder materielle Güter ausgeht, abzusichern. Beim Öffnen der Schutztür oder beim Betätigen des Not-Aus-Tasters wird jeweils ein Signal erzeugt, das der Sicherheitssteuerung als Eingangssignal zugeführt ist. In Reaktion darauf schaltet die Sicherheitssteuerung dann bspw. mit Hilfe eines Aktuators den gefahrbringenden Teil der Maschine ab.

Charakteristisch an einer Sicherheitssteuerung ist im Gegensatz zu einer "normalen" Steuerung, dass die Sicherheitssteuerung selbst dann, wenn bei ihr oder einem mit ihr verbundenen Gerät eine Fehlfunktion auftritt, stets einen sicheren Zustand der Gefahr bringenden Anlage oder Maschine gewährleisten muss. Daher werden bei Sicherheitssteuerungen extrem hohe Anforderungen an die eigene Fehlersicherheit gestellt, was einen erheblichen Aufwand bei der Entwicklung und Herstellung zur Folge hat. In der Regel benötigen Sicherheitssteuerungen vor ihrer Verwendung eine besondere Zulassung durch zuständige Aufsichtsbehörden, wie bspw. in Deutschland durch die Berufsgenossenschaften oder den TÜV. Die Sicherheitssteuerung muss dabei vorgegebene Sicherheitsstandards einhalten, die bspw. in der europäischen Norm EN 954-1 oder einer vergleichbaren Norm, beispielsweise der Norm IEC 61508 oder der Norm EN ISO 13849-1 niedergelegt sind. Im Folgenden wird daher unter einer Sicherheitssteuerung ein Gerät bzw. eine Vorrichtung verstanden, die zumindest die Sicherheitskategorie 3 der genannten europäischen Norm erfüllt.

Eine programmierbare Sicherheitssteuerung bietet dem Anwender die Möglichkeit, die logischen Verknüpfungen und ggf. weiteren Signal- oder Datenverarbeitungsschritte mit Hilfe einer Software, dem sog. Anwenderprogramm, seinen Bedürfnissen entsprechend individuell festzulegen. Daraus resultiert eine große Flexibilität im Vergleich zu früheren Lösungen, bei denen die logischen Verknüpfungen durch eine definierte Verdrahtung zwischen verschiedenen Sicherheitsbausteinen erzeugt wurden. Ein Anwenderprogramm kann bspw. mit Hilfe eines handelsüblichen Personal Computers (PC) und unter Verwendung entsprechend eingerichteter Softwareprogramme erstellt werden.

Ein so erstelltes Anwenderprogramm muss auf die Sicherheitssteuerung, auf der es laufen soll, aufgespielt werden. D.h. es muss an diese übertragen und in einem dafür vorgesehen Speicher abgelegt werden. Für die Übertragung eines Anwenderprogramms, insbesondere nach Abänderung eines bereits existierenden Anwenderprogramms, wird der Personal Computer üblicherweise an eine Datenfernübertragungseinheit, beispielsweise an ein Bussystem angeschlossen. Diese Vorgehensweise ist aufwändig. Sind mehrere Maschinen oder Anlagen in einem Gebäude aufgestellt, muss diejenige Sicherheitssteuerung, auf die das Anwenderprogramm aufgespielt werden soll, softwaremäßig angewählt werden. Außerdem erfordert die Übertragung des Anwenderprogramms über ein Bussystem entsprechend strenge Sicherungsvorkehrungen, damit später ein fehlersicherer Betrieb des Anwenderprogramms gewährleistet ist. Einfacher ist es dagegen, wenn sich das Anwenderprogramm auf einem Datenträger befindet, der über eine Aufnahmeeinheit direkt an die Sicherheitssteuerung angeschlossen werden kann. Zum einen entfällt die softwaremäßige Anwahl der Sicherheitssteuerung. Zum anderen entfallen die strengen Sicherungsvorkehrungen. Darüber hinaus ist das Einlesen in einen Speicher nicht erforderlich, da der Datenträger selbst als Speicher fungiert. Der Einsatz eines Datenträgers erleichtert jedoch nicht nur das Aufspielen von Anwenderprogrammen auf eine Sicherheitssteuerung. Er vereinfacht auch die Vergabe von Adressdaten für eine Teilkomponente einer Sicherheitssteuerung oder die Aktualisierung von Instandhaltungsdaten. Vor allem aber zeichnet sich der Einsatz eines Datenträgers bei der Handhabe von Eingriffs- bzw. Zugriffsberechtigungen auf Sicherheitssteuerungen oder Teilkomponenten derselben aus. Eingriffs- bzw. Zugriffsberechtigungen ermöglichen es, eine Sicherheitssteuerung oder eine Teilkomponente von einem Automatikbetrieb, bei dem das Anwenderprogramm abgearbeitet wird, in einen sog. Sonderbetrieb umzustellen. Bei einem Sonderbetrieb sind in der Sicherheitssteuerung vorhandene Schutzeinrichtungen gezielt überbrückt, d.h. deren Schutzwirkung wird aufgehoben. Somit kann ein Bediener bspw. Einstell- oder Wartungsarbeiten an der von der Sicherheitssteuerung gesteuerten Maschine vornehmen.

In DE 100 37 003 A1 ist ein Datenträger beschrieben, der bei einem System zum Prüfen einer Eingriffsberechtigung in rechnergestützte Steuereinrichtungen von Maschinen bzw. Anlagen eingesetzt wird. Der Datenträger weist ein Speicherelement auf, in dem die Eingriffsberechtigung abgelegt ist. Das Speicherelement arbeitet nach dem Transponderprinzip, so dass die Signalübertragung zwischen dem Datenträger und einer mit der Steuereinrichtung verbundenen Prüfeinrichtung elektrischkontaktlos erfolgt. Der Datenträger wird in die Prüfeinrichtung, die eine fixierende Schlüsselhalteeinrichtung aufweist, eingebracht. Die Fixierung des Schlüssels erfolgt durch in der Schlüsselhalteeinrichtung angeordnete, mit dem Schlüssel zusammenwirkende Rastmittel. Hierzu sind die Rastmittel bewegbar ausgebildet. Der Schlüssel selbst weist keine bewegbaren Elemente auf, durch die er an der Prüfeinrichtung fixiert bzw. befestigt werden kann.

Der bekannte Datenträger vereinfacht zwar die Übertragung von Daten auf eine Sicherheitssteuerung, da hierfür keine Anbindung an ein Datenfernübertragungseinheit erforderlich ist. Der bekannte Datenträger und das damit verbundene Konzept sind jedoch hinsichtlich der Gestaltung der für die Sicherheitssteuerung verwendeten Gehäuse nachteilig. Dies hängt damit zusammen, dass bei diesem Konzept die für die Befestigung bzw. Fixierung des Datenträgers erforderlichen bewegbaren Elemente ausschließlich im Gehäuse der Sicherheitssteuerung angeordnet sind. In der Herstellung sind große Gehäuse, die bewegbare Elemente aufweisen, sehr aufwändig und somit teuer. Unter Gehäuse wird in diesem Zusammenhang diejenige Einheit verstanden, in der die eigentlichen elektrischen bzw. elektronischen Steuerungskomponenten ortsfest, üblicherweise im Bereich der zu steuernden Maschine oder Anlage untergebracht sind. Die Anzahl der Gehäuse hängt dabei vom Aufbau der Sicherheitssteuerung ab. Ist die Sicherheitssteuerung als Einzelsteuerung realisiert, so handelt es sich um ein einzelnes Gehäuse, das Gehäuse der Sicherheitssteuerung. Ist die Sicherheitssteuerung dagegen modular bzw. verteilt aufgebaut, so handelt es sich um eine Vielzahl von Gehäuse. In der Regel um so viele Gehäuse, wie die Sicherheitssteuerung Teilkomponenten aufweist. Es handelt sich dann um ein Gehäuse der Teilkomponente.

Wenn nachfolgend die Rede davon ist, dass der Datenträger an dem Gehäuse der Sicherheitssteuerung angebracht ist, so bedeutet dies Folgendes: Ist die Sicherheitssteuerung als Einzelsteuerung realisiert, dann ist der Datenträger an dem Gehäuse dieser Einzelsteuerung angebracht. Ist die Sicherheitssteuerung dagegen modular aufgebaut, dann ist der Datenträger an dem Gehäuse einer der Teilkomponenten der Sicherheitssteuerung angebracht.

Es ist daher eine Aufgabe der vorliegenden Erfindung, eine Sicherheitssteuerung der eingangs genannten Art weiterzubilden, um eine einfache und wenig aufwändige Gestaltung und somit kostengünstige Herstellung der Gehäuse zu erreichen.

Diese Aufgabe wird bei der eingangs genannten Sicherheitssteuerung dadurch gelöst, dass der Datenträger zumindest ein Befestigungselement aufweist, welches derart relativ zu dem Trägerelement bewegbar ist, dass es dadurch mit der Aufnahmeeinheit zusammenwirken kann, wodurch der Datenträger an der Aufnahmeeinheit befestigt wird, wobei die Aufnahmeeinheit zumindest ein Halteelement aufweist, wobei das Befestigungselement und das Halteelement derart ausgebildet sind, dass der Datenträger zumindest durch eine sich zwischen dem Befestigungselement und dem Halteelement einstellende formschlüssige Verbindung an der Aufnahmeeinheit befestigt wird, und wobei das Befestigungselement eine Rastnase und eine von dieser beabstandete Sicherungskante aufweist, und dass das Halteelement eine Rastkante und eine von dieser beabstandete Haltekante aufweist, wobei die formschlüssige Verbindung dadurch entsteht, dass die Rastnase die Rastkante hintergreift und die Sicherungskante auf der Haltekante aufliegt.

Dadurch, dass der Datenträger ein relativ zu seinem Trägerelement bewegbares Befestigungselement aufweist, mit dem sich die Befestigung des Datenträgers an einer in der Einrichtung angeordneten Aufnahmeeinheit realisieren lässt, ist die Gestaltung zugehöriger Gehäuse weniger aufwändig und somit deren Herstellung kostengünstiger als im Fall des bekannten Datenträgers. Durch die bauliche Zuordnung des bewegbaren Befestigungselements zum Datenträger, sind an den Gehäusen keine Elemente erforderlich, die über die Gehäusekontur hinausragen. Gerade solche Elemente erfordern zusätzliche Maßnahmen bei der Entformung. Da für die Herstellung von Gehäusen große Werkzeuge bzw. Formen benötigt werden, sind solche zusätzlichen Maßnahmen sehr aufwändig und damit kostenintensiv. Werden dagegen an einem Datenträger zusätzliche Maßnahmen realisiert, so entstehen dadurch geringere zusätzliche Kosten. Für die Herstellung des Datenträgers werden kleinere Werkzeuge bzw. Formen benötigt, weswegen zusätzliche Maßnahmen nicht so aufwändig und somit nicht so kostenintensiv sind. Zudem kann auf die nachträgliche Anbringung von federnden Elementen an den Gehäusen verzichtet werden. Auch hierfür sind kostenintensive bauliche Maßnahmen an den Gehäusen erforderlich, beispielsweise das Vorsehen von Gewinden.

Darüber hinaus ist hinsichtlich des Austauschs von Verschleißteilen die Anbringung des bewegbaren Befestigungselements am Datenträger vorteilhaft. So lässt sich ein an einem Datenträger angebrachtes Befestigungselement wesentlich leichter austauschen, als ein in einem Gehäuse angebrachtes.

Die Aufnahmeeinheit weist zumindest ein Halteelement auf, wobei das Befestigungselement und das Halteelement derart ausgebildet sind, dass der Datenträger zumindest durch eine sich zwischen dem Befestigungselement und dem Halteelement einstellende formschlüssige Verbindung an der Aufnahmeeinheit befestigt wird.

Diese Maßnahme ermöglicht eine gesicherte Befestigung des Datenträgers an der Aufnahmeeinheit. Eine formschlüssige Verbindung entsteht dadurch, dass mindestens zwei Verbindungspartner ineinandergreifen. Durch das Ineinandergreifen des Befestigungselements und des Halteelements wird der Datenträger an der Aufnahmeeinheit gegen Herausfallen gesichert. Der Datenträger kann sich somit nicht selbsttätig aus der Aufnahmeeinheit lösen. Zusätzliche Maßnahmen, wie beispielsweise das Sichern des Datenträgers mittels eines Kabelbinders an der Aufnahmeeinheit, sind nicht mehr erforderlich.

Des weiteren weist das Befestigungselement eine Rastnase und eine von dieser beabstandete Sicherungskante auf und weist das Halteelement eine Rastkante und eine von dieser beabstandete Haltekante auf, wobei die formschlüssige Verbindung dadurch entsteht, dass die Rastnase die Rastkante hintergreift und die Sicherungskante auf der Haltekante aufliegt.

Diese Maßnahme stellt eine einfache Realisierungsform einer formschlüssigen Verbindung dar. Ein Befestigungselement mit einer Rastnase und einer Sicherungskante zeichnet sich durch einen einfachen konstruktiven Aufbau aus. Die hierfür erforderlichen Herstellungswerkzeuge sind wenig komplex und somit kostengünstig. Auch das Halteelement, welches zur Realisierung der formschlüssigen Verbindung lediglich eine Rastkante und eine Haltekante aufweisen muss, ist einfach aufgebaut und somit kostengünstig herstellbar. Der Datenträger ist bei dieser Realisierungsform zuverlässig in zwei Richtungen gegen eine ungewollte bzw. unbeabsichtigte Bewegung gesichert. Gleichzeitig ermöglicht diese Ausführungsform eine einfache Handhabe: der Datenträger lässt sich mit einem einfachen Handgriff wieder aus der Aufnahmeeinheit entfernen.

In einer bevorzugten Ausgestaltung der Erfindung beschreiben oder beeinflussen die in dem Speicherelement abgelegten Daten einen Zustand und/oder eine Eigenschaft des Steuerungssystems oder zumindest einer Teilkomponente des Steuerungssystems.

Insgesamt handelt es sich somit bei dieser Ausgestaltung um einen Datenträger mit einem Trägerelement, welches ein Speicherelement trägt, wobei in dem Speicherelement Daten abgelegt sind, die einen Zustand und/oder eine Eigenschaft des Steuerungssystems oder zumindest einer Teilkomponente des Steuerungssystems beschreiben oder beeinflussen, wobei der Datenträger zumindest ein Befestigungselement aufweist, welches derart relativ zu dem Trägerelement bewegbar ist, dass es dadurch mit einer in dem Steuerungssystem angeordneten Aufnahmeeinheit zusammenwirken kann, wodurch der Datenträger an der Aufnahmeeinheit befestigt wird.

In einer bevorzugten Ausgestaltung der Erfindung wirken das Befestigungselement und die Aufnahmeeinheit derart zusammen, dass eine selbsthemmende Verbindung entsteht.

Unter einer selbsthemmenden Verbindung im Sinne der vorliegenden Erfindung wird eine Verbindung verstanden, die dazu führt, dass sich zwei oder mehr zusammenwirkende Körper nicht selbständig bewegen und somit voneinander lösen können. Die sich zwischen dem Befestigungselement und der Aufnahmeeinheit ausbildende selbsthemmende Verbindung führt somit dazu, dass sich der in der Aufnahmeeinheit befestigte Datenträger nicht selbständig von dieser lösen kann. Dadurch kann auf zusätzliche sichernde Maßnahmen wie beispielsweise das Sichern des Datenträgers mit Hilfe einer Plombe an der Aufnahmeeinheit verzichtet werden. Es entfallen somit zusätzliche Handgriffe bei der Anbringung des Datenträgers an der Aufnahmeeinheit. Darüber hinaus kann der Einbau- bzw. Anbringungsort der Aufnahmeeinheit und somit der Daten aufnehmenden Einrichtung beliebig gewählt werden. So kann die Einrichtung beispielweise hängend an einer Maschine oder Anlage oder Hallendecke montiert werden. Durch die selbsthemmende Verbindung ist der Datenträger gegen Herausfallen gesichert. Es sind keine zusätzlichen Befestigungsmaßnahmen erforderlich.

In einer weiteren Ausgestaltung der Erfindung ist die Aufnahmeeinheit derart schachtförmig ausgebildet, dass der Datenträger zumindest mit seinem Trägerelement in die Aufnahmeeinheit eingeführt werden kann.

Durch diese Maßnahme ist der in der Sicherheitssteuerung angeordnete Datenträger geschützt. Er steht nicht von der Aufnahmeeinheit und somit dem Gehäuse der Sicherheitssteuerung ab. Dadurch kann er beim Vorbeiführen von Gegenständen nicht unbeabsichtigt abgestreift oder beschädigt werden. Zudem ermöglicht diese Maßnahme eine kostengünstige, weil einfache Realisierung der für die Sicherheitssteuerung erforderlichen Hardware. Dadurch, dass der Datenträger in die Aufnahmeeinheit eingeführt werden kann, kann das Speicherelement in unmittelbare Nähe einer für den Datenaustausch zwischen ihm und der Sicherheitssteuerung erforderlichen Kontaktier- oder Übertragungseinheit gebracht werden. Diese Einheit kann somit unmittelbar auf der Hauptplatine der Sicherheitssteuerung angebracht werden. Es sind keine zusätzlichen Maßnahmen, wie beispielsweise zusätzliche mechanische Anbringungselemente oder elektrische Verbindungen erforderlich, die benötigt würden, wenn diese Einheit baulich in die Nähe des Datenträgers zu bringen wäre.

In einer weiteren Ausgestaltung ist die Rastnase derart ausgebildet, dass sich das Befestigungselement beim Einführen des Trägerelements in die Aufnahmeeinheit von einem in der Aufnahmeeinheit angeordneten Halteelement wegbewegt, sobald die Rastnase an dem Halteelemente anliegt, und sich das Befestigungselement zurückbewegt und eine Ruheposition einnimmt, sobald die Rastnase unter Beibehaltung der Einführbewegung das Halteelement passiert hat.

Die so ausgebildete Rastvorrichtung hat den Vorteil, dass sie selbsttätig einrastet und somit einfach in der Handhabe ist. Der Datenträger muss zum Einführen in die Aufnahmeeinheit lediglich auf diese aufgesetzt und unter Druck in diese hineinbewegt werden. Ist der Datenträger genügend weit in die Aufnahmeeinheit eingeführt, stellt sich die formschlüssige Verbindung von selbst ein. Lediglich bei der Entnahme des Datenträgers aus der Aufnahmeeinheit ist ein zusätzlicher Handgriff erforderlich, da die formschlüssige Verbindung erst nach Betätigung des Befestigungselements gelöst werden kann. Das Befestigungselement muss von dem Halteelement wegbewegt werden. Vorteilhafterweise weist die Rastnase ein angeschrägtes, insbesondere ein dreieckförmiges Profil auf.

In einer weiteren Ausgestaltung der Erfindung weist der Datenträger ein Griffelement auf, an dem das Befestigungselement bewegbar angebracht ist.

Generell ermöglicht ein Datenträger mit einem Griffelement eine einfache Handhabe, was das Befestigen an und das Lösen von einer Aufnahmeeinheit angeht. Insbesondere hinsichtlich der formschlüssigen Verbindung ist die bewegbare Anbringung des Befestigungselementes an dem Griffelement von Vorteil. Beim Einführen des Datenträgers in die Aufnahmeeinheit lässt sich die von dem Befestigungselement auszuführende Bewegung unterstützen. Beim Entfernen des Datenträgers aus der Aufnahmeeinheit kann das hierfür erforderliche Lösen des Befestigungselementes von dem Halteelement in einfacher Art und Weise realisiert werden. Auch hinsichtlich der kraftschlüssigen Verbindung ist diese Anbringungsart von Vorteil. So kann beim Einführen des Datenträgers in die Aufnahmeeinheit durch eine entsprechende Bewegung des Griffelementes und somit des Befestigungselementes eine Verzögerung im Aufbau der Vorspannung erreicht werden, wodurch das Einführen erleichtert wird. Ebenso kann beim Entfernen des Datenträgers aus der Aufnahmeeinheit durch eine entsprechende Bewegung des Griffelementes und somit des Befestigungselementes die sich abbauende Vorspannung derart beeinflusst werden, dass das Entfernen erleichtert wird.

In einer weiteren Ausgestaltung der zuvor genannten Maßnahme sind das Griffelement und das Befestigungselement einstückig miteinander verbunden.

Diese Maßnahme hat verschiedene Vorteile. Die aus dem Griffelement und dem Befestigungselement bestehende einstückige Baueinheit lässt einfach herstellen. Im Vergleich zu einer mehrteiligen Ausführung ist die Anzahl der erforderlichen Herstellungswerkzeuge geringer, was zu geringeren Herstellungskosten führt. Zudem ist keine zusätzliche Montage erforderlich, um das Befestigungselement an dem Griffelement anzubringen. Darüber hinaus ist das Befestigungselement definiert und somit stabil an dem Griffelement angebracht. Dadurch wird ein ggf. zwischen dem Befestigungselement und dem Halteelement auftretendes, die formschlüssige Verbindung beeinträchtigendes Spiel auf ein Minimum reduziert.

In einer weiteren Ausgestaltung der Erfindung weist der Datenträger zwei Befestigungselemente auf.

Diese Maßnahme ermöglicht eine besonders stabile Befestigung des Datenträgers an der Aufnahmeeinheit. Insbesondere ist es von Vorteil, wenn sich die beiden Befestigungselemente gegenüberliegen. Dadurch wird der Datenträger zentriert in der Aufnahmeeinheit gehalten und nimmt eine genau definierte Lage ein.

In einer weiteren Ausgestaltung der Erfindung besteht der Datenträger aus zwei Schalenelementen.

Dieser konstruktive Aufbau des Datenträgers ermöglicht ein einfaches Einfügen des Speicherelementes in den Datenträger. Zudem lässt sich der Datenträger in einfacher Art und Weise zusammenbauen. Besteht der Datenträger beispielsweise aus Kunststoff, können die beiden Schalenelemente mit Hilfe eines geeigneten Schweißverfahrens zusammenfügt werden.

In einer weiteren Ausgestaltung der Erfindung handelt es sich bei den Daten um Zugriffsberechtigungsdaten, die die Zugriffsberechtigung auf die Sicherheitssteuerung oder zumindest eine Teilkomponente der Sicherheitssteuerung beschreiben, und/oder um Adressdaten, die die Adresse zumindest einer Teilkomponente der Sicherheitssteuerung beschreiben, und/oder um ein auf der Sicherheitssteuerung ablaufendes Anwenderprogramm, und/oder um Instandhaltungsdaten, die die für die Sicherheitssteuerung oder zumindest eine Teilkomponente der Sicherheitssteuerung durchzuführenden Wartungs- oder Inspektionsarbeiten beschreiben.

Die Übertragung von Daten auf eine Sicherheitssteuerung unter Verwendung eines mobilen Datenträgers stellt eine einfache, weil unaufwändige Maßnahme dar, mit der zugleich rasch auf äußere Gegebenheiten reagiert werden kann. Handelt es sich bei den auf dem Datenträger abgelegten Daten um Zugriffsberechtigungsdaten, so kann unmittelbar nach Einbringen des Datenträgers in die Aufnahmeeinheit, die dem Besitzer des Datenträgers zustehende Zugriffsberechtigung ausgelesen werden und die Sicherheitssteuerung in einen der Zugriffsberechtigung entsprechenden Sonderbetriebsmodus überführt werden. Somit ist es möglich, zeitnah auf äußere Umstände reagieren zu können und entsprechende Maßnahmen an der Sicherheitssteuerung vornehmen zu können. Beispielsweise kann an der Sicherheitssteuerung rasch eine erforderliche Einstellung vorgenommen werden oder ohne großen Zeitverzug ein defektes Werkzeug ausgetauscht werden. Entsprechendes gilt auch für eine Teilkomponente der Sicherheitssteuerung. Handelt es sich bei den auf dem Datenträger abgelegten Daten um Adressdaten, so kann unmittelbar nach Einführen des Datenträgers in die Aufnahmeeinheit, die für eine Teilkomponente der Sicherheitssteuerung geltende neue Adresse ausgelesen werden. Zudem ist eine initialisierende Adressvergabe einfach zu realisieren. Somit lassen sich Adressdaten von Teilkomponenten einfach vergeben bzw. abändern. Handelt es sich bei den auf dem Datenträger abgelegten Daten um ein Anwenderprogramm, so kann dieses unmittelbar nach Einführen des Datenträgers in die Aufnahmeeinheit ausgelesen werden. Dies ermöglicht kurzfristig, ein auf einer Sicherheitssteuerung befindliches Anwenderprogramm durch ein abgeändertes Anwenderprogramm zu ersetzen. Handelt es sich bei den auf dem Datenträger abgelegten Daten um Instandhaltungsdaten, so können die in einer Sicherheitssteuerung oder einer Teilkomponente der Sicherheitssteuerung hinterlegten ursprünglichen Instandhaltungsdaten in einfacher Art und Weise abgeändert oder ersetzt werden. Die Instandhaltungsdaten enthalten unter anderem Vorgaben für Wartung und/oder Inspektion.

In einer weiteren Ausgestaltung der Erfindung ist das Speicherelement derart ausgebildet, dass mittels der in der Sicherheitssteuerung angeordneten Ein-/Ausgabeeinheit sowohl Daten von dem Speicherelement ausgelesen als auch Daten auf das Speicherelement geschrieben werden können.

Somit besteht beispielsweise die Möglichkeit, dezentral an der jeweiligen Sicherheitssteuerung oder an einer Teilkomponente einer Sicherheitssteuerung Daten zu sammeln und zu einem späteren Zeitpunkt zentral an einem speziell dafür eingerichteten Rechner auszuwerten.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung einer Sicherheitssteuerung, bei der ein erfindungsgemäßer Datenträger zum Einsatz kommt;
- Fig. 2: eine schematische Darstellung der räumlichen Aufteilung der einzelnen Komponenten einer Sicherheitssteuerung;
- Fig. 3: eine vereinfachte Darstellung eines Gehäuses einer Sicherheitssteuerung oder einer Teilkomponente einer Sicherheitssteuerung an dem ein erfindungsgemäßer Datenträger angebracht wird;
- Fig. 4: in Teilfiguren 4a bis 4f verschiedene Ansichten und Schnitte eines ersten Ausführungsbeispiels eines erfindungsgemäßen Datenträgers;
- Fig. 5: in Teilfiguren 5a bis 5f verschiedene Ansichten und Schnitte eines zweiten Ausführungsbeispiels eines erfindungsgemäßen Datenträgers;
- Fig. 6: eine Schnittdarstellung eines erfindungsgemäßen Datenträgers gemäß erstem Ausführungsbeispiel in einem in eine Aufnahmeeinheit eingeführten Zustand; und
- Fig. 7: eine Schnittdarstellung eines erfindungsgemäßen Datenträgers gemäß zweitem Ausführungsbeispiel in einem in eine Aufnahmeeinheit eingeführten Zustand.

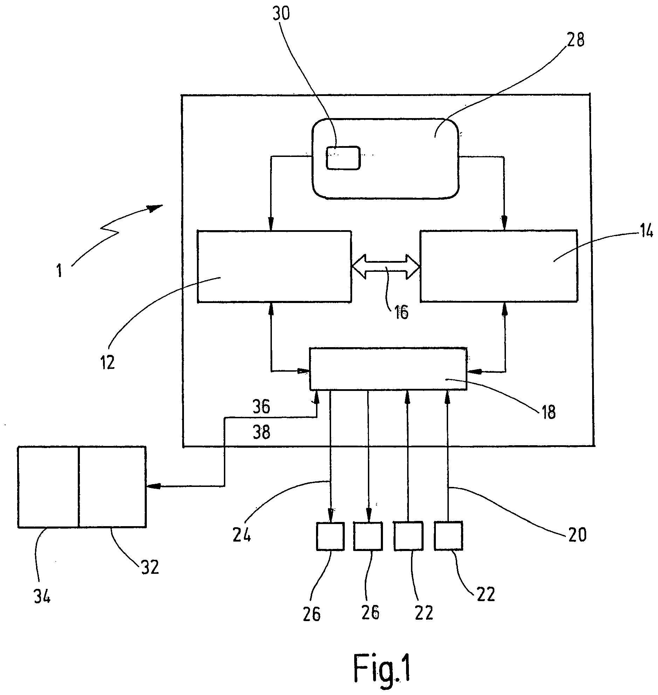

In Fig. 1 ist eine Sicherheitssteuerung, die zur Aufnahme eines erfindungsgemäßen Datenträgers ausgebildet ist, in ihrer Gesamtheit mit der Bezugsziffer 1 bezeichnet.

Die Sicherheitssteuerung 1 ist zweikanalig-redundant aufgebaut, um die erforderliche Fehlersicherheit zum Steuern sicherheitskritischer Prozesse zu erreichen. Stellvertretend für den zweikanaligen Aufbau sind in Fig. 1 zwei voneinander getrennte Prozessoren 12, 14 dargestellt, die über eine bidirektionale Kommunikationsschnittstelle 16 miteinander in Verbindung stehen, um sich gegenseitig kontrollieren und Daten austauschen zu können. Bevorzugt sind die beiden Kanäle der Sicherheitssteuerung 1 und die beiden Prozessoren 12, 14 diversitär, d.h. verschieden voneinander aufgebaut, um systematische Fehler weitgehend auszuschließen.

Mit der Bezugsziffer 18 ist eine Ein-/Ausgabeeinheit bezeichnet, die mit jedem der beiden Prozessoren 12, 14 in Verbindung steht. Die Ein-/Ausgabeeinheit nimmt Eingangssignale 20 von externen Sensoren 22 auf und leitet diese in einem angepassten Datenformat an jedem der beiden Prozessoren 12, 14 weiter. Ferner erzeugt die Ein-/Ausgabeeinheit in Abhängigkeit von den Prozessoren 12, 14 Ausgangssignale 24, mit denen Aktuatoren 26 angesteuert werden. Bei den Sensoren 22 handelt es sich beispielsweise um Not-Aus-Taster, Zwei-Hand-Steuerungen, Schutztüren, Drehzahlüberwachungsgeräte oder andere Sensoren zur Aufnahme sicherheitsrelevanter Parameter. Die Aktuatoren 26 sind beispielsweise sogenannte Schütze, mit denen die Stromversorgung eines Antriebes oder einer kompletten Maschine abgeschaltet werden kann.

Mit der Bezugsziffer 28 ist ein Speicher bezeichnet, in dem ein Anwenderprogramm 30 abgespeichert wird. Das Anwenderprogramm 30 wird mit Hilfe eines sog. Programmiertools erstellt. Das Anwenderprogramm legt die von der Sicherheitssteuerung 1 durchzuführenden Steuerungsaufgaben fest. Bei dem Speicher 28 kann es sich um einen fest in der Sicherheitssteuerung 1 eingebauten Speicher, beispielsweise ein EEPROM, handeln. Aus Gründen der Übersichtlichkeit ist das vorstehend erwähnte Programmiertool in Fig. 1 nicht dargestellt. Der Vollständigkeit halber sei jedoch erwähnt, dass solch ein Programmiertool üblicherweise einen herkömmlichen PC mit einem Monitor beinhaltet, auf dem ein Computerprogramm ausgeführt wird. Das Computerprogramm ermöglicht die Erstellung eines Anwenderprogramms für eine Sicherheitssteuerung.

Mit Bezugsziffer 32 ist eine Aufnahmeeinheit bezeichnet, an der ein erfindungsgemäßer Datenträger 34 befestigt werden kann. Auf dem Datenträger 34 befindliche Daten 36 können dann an die Sicherheitssteuerung 1 übertragen werden. Bei diesen Daten 36 kann es sich beispielsweise um Zugriffsberechtigungsdaten und/oder um Adressdaten und/oder um ein Anwenderprogramm und/oder um Instandhaltungsdaten handeln. Im Falle eines Anwenderprogramms kann somit das ursprünglich in Speicher 28 befindliche Anwenderprogramm 30 durch das auf dem Datenträger 34 befindliche Anwenderprogramm ersetzt werden. Ferner ist es möglich, Daten 38 ausgehend von der Sicherheitssteuerung 1 auf den Datenträger 34 zu übertragen und dort abzuspeichern.

Die in Fig. 1 gezeigte Anbindung der Aufnahmeeinheit 32 und somit des Datenträgers 34 über die Ein-/Ausgabeeinheit 18 an die Sicherheitssteuerung 1 soll keine einschränkende Wirkung haben. Ebenso ist eine direkte Anbindung an den Speicher 28 denkbar. Dies kann beispielweise dann in Betracht kommen, wenn auf dem Datenträger 34 ein Anwenderprogramm abgelegt ist.

Wenn die Rede davon ist, dass der Datenträger 34 an der Aufnahmeeinheit 32 befestigt wird, bedeutet dies nicht, dass der Datenträger 34 nach Anbringung an der Aufnahmeeinheit 32 dauerhaft an dieser verbleibt. Vielmehr ist der Datenträger 34 lösbar mit der Aufnahmeeinheit 32 verbunden.

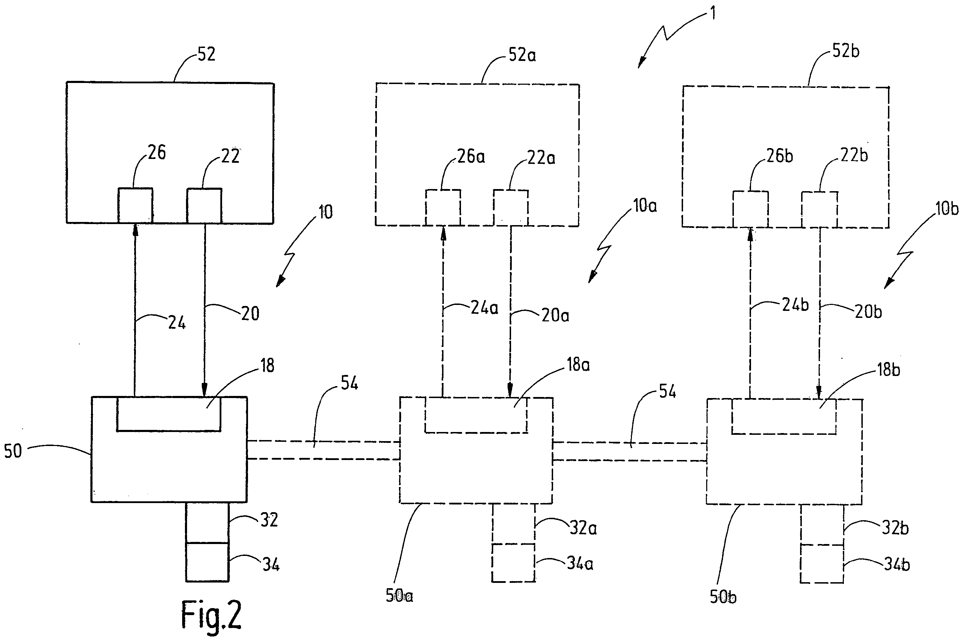

In Fig. 2 ist in einer vereinfachten Darstellung die räumliche Anordnung verschiedener Komponenten der Sicherheitssteuerung 1 dargestellt. Dabei gilt Folgendes: Handelt es sich bei der Sicherheitssteuerung 1 um eine Einzelsteuerung, so entspricht diese einer mit der Bezugsziffer 10 bezeichneten Teilkomponente. Ist die Sichersteuerung 1 dagegen modular aufgebaut, so setzt sich diese aus mehreren Teilkomponenten 10, 10a, 10b zusammen. Die gewählte Darstellung mit drei Teilkomponenten soll allerdings keine einschränkende Wirkung haben. Eine Sicherheitssteuerung kann auch aus zwei oder mehr als drei Teilkomponenten bestehen. Unabhängig von der konkreten Realisierungsform der Sicherheitssteuerung 1 weist jede der Teilkomponenten 10, 10a, 10b die im Zusammenhang mit der Fig. 1 beschriebene, für eine Sicherheitssteuerung geforderte Grundfunktionalität auf.

Zunächst wird eine als Einzelsteuerung realisierte Sicherheitssteuerung 1 betrachtet, d.h. die Sicherheitssteuerung 1 entspricht der Teilkomponente 10. Mit Bezugsziffer 50 ist eine Sicherheitssteuereinheit bezeichnet, mit der eine Maschine oder Anlage 52 sicherheitsgesteuert wird. Hierzu werden mittels der in der Maschine oder Anlage 52 angeordneten Sensoren 22 Signale erzeugt, die als Eingangssignale 20 der in der Sicherheitssteuereinheit 50 angeordneten Ein-/Ausgabeeinheit 18 zugeführt werden. Aus den Eingangssignalen 20 werden in der Sicherheitssteuereinheit 50 Ansteuersignale erzeugt, die dann als Ausgangssignale 24 über die Ein-/Ausgabeeinheit 18 den in der Maschine oder Anlage 52 angeordneten Aktuatoren 26 zugeführt werden. Auf die Darstellung der eigentlichen Steuerungskomponenten, hierbei handelt es sich um die in Fig. 1 dargestellten Komponenten 12, 14, 16, 28 und 30, die allesamt der Sicherheitssteuereinheit 50 zuzuordnen sind, wird aus Gründen der Übersichtlichkeit verzichtet. Der Sicherheitssteuereinheit 50 ist die Aufnahmeeinheit 32 zugeordnet, die der Aufnahme des Datenträgers 34 dient. Die Übertragung der auf dem Datenträger 34 abgelegten Daten an die Sicherheitssteuereinheit 50 erfolgt wie im Zusammenhang mit Fig. 1 beschrieben. Auf dem Datenträger 34 Daten sind abgelegt, die einen Zustand und/oder eine Eigenschaft der Sicherheitssteuerung 1 beschreiben oder beeinflussen.

Handelt es sich dagegen bei der Sicherheitssteuerung 1 um eine modular aufgebaute, wie es beispielsweise bei sehr komplexen oder sehr großen Maschinen bzw. Anlagen der Fall ist, so sind neben den vorstehend beschriebenen Komponenten weitere, in Fig. 2 strichliniert dargestellte Komponenten zu berücksichtigen. Die Sicherheitssteuerung 1 besteht dann aus den Teilkomponenten 10, 10a, 10b; neben der Sicherheitssteuereinheit 50 existieren weitere Sicherheitssteuereinheiten 50a, 50b. Die insgesamt zu steuernde Anlage oder Maschine besteht aus Maschinenteilkomponenten 52, 52a, 52b. Insgesamt gilt folgende Zuordnung: Die Sicherheitssteuereinheit 50 ist der Maschinenteilkomponente 52 zugeordnet und übernimmt deren Steuerung. Die Sicherheitssteuereinheit 50a ist der Maschinenteilkomponente 52a zugeordnet und übernimmt deren Steuerung. Die Sicherheitssteuereinheit 50b ist einer Maschinenteilkomponente 52b zugeordnet und übernimmt deren Steuerung. Dies erfolgt jeweils nach dem oben für die als Einzelsteuerung realisierte Sicherheitssteuerung beschriebenen Schema. Die einzelnen Sicherheitssteuereinheiten 50, 50a, 50b sind untereinander über eine Datenübertragungseinheit 54 verbunden, wobei üblicherweise eine der Sicherheitssteuereinheiten 50, 50a, 50b die Koordinaten aller übernimmt. Diese wird dann als Master, die anderen als Slave bezeichnet. Bei der Datenübertragungseinheit 54 kann es sich beispielsweise um ein bei Sicherheitssteuerungen üblicherweise eingesetztes Bussystem handeln. Der Sicherheitssteuereinheit 50a ist eine Aufnahmeeinheit 32a zur Aufnahme eines Datenträgers 34a und der Sicherheitssteuereinheit 50b ist eine Aufnahmeeinheit 32b zur Aufnahme eines Datenträgers 34b zugeordnet.

Die auf dem Datenträger 34, 34a, 34b abgelegten Daten beschreiben oder beeinflussen einen Zustand und/oder eine Eigenschaft derjenigen Teilkomponente 10, 10a, 10b der Sicherheitssteuerung 1, an deren Aufnahmeeinheit 32, 32a, 32b der Datenträger 34, 34a, 34b befestigt ist. So sind die auf dem Datenträger 34 abgelegten Daten für die Sicherheitssteuereinheit 50, die auf dem Datenträger 34a abgelegten Daten für die Sicherheitssteuereinheit 50a und die auf dem Datenträger 34b abgelegten Daten für die Sicherheitssteuereinheit 50b bestimmt. Es ist aber auch denkbar, dass die auf einem Datenträger 34, 34a, 34b abgelegten Daten alle Teilkomponenten 10, 10a, 10b und somit alle Sicherheitssteuereinheiten 50, 50a, 50b beeinflussen können oder für diese bestimmt sein können. Dies ist dann der Fall, wenn es sich bei den Daten um ein Anwenderprogramm handelt, welches auf dem Datenträger derjenigen Teilkomponente und somit Sicherheitssteuereinheit abgelegt ist, die die Koordination der anderen Teilkomponenten bzw. Sicherheitssteuereinheiten übernimmt.

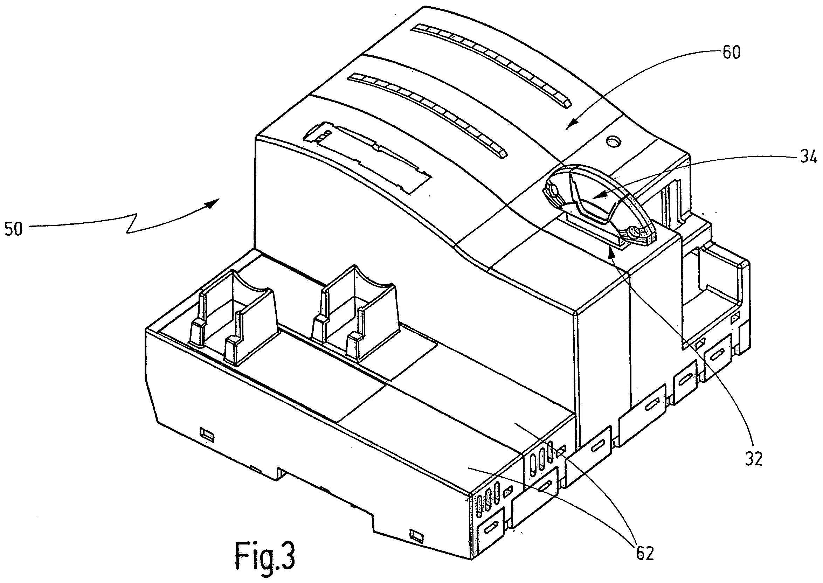

In Fig. 3 ist die Gehäuseanordnung der in Fig. 2 dargestellten Sicherheitssteuereinheit 50 dargestellt. Die beiden anderen in Fig. 2 dargestellten Sicherheitssteuereinheiten 50a, 50b können ebenfalls diese Gehäuseanordnung aufweisen.

Die Sicherheitssteuereinheit 50 ist in einem vorzugsweise aus Kunststoff bestehenden Gehäuse 60 untergebracht. Das Gehäuse 60 weist eine Aufnahmeeinheit 32 auf, in die ein Datenträger 34 eingeführt und befestigt werden kann. Der Datenträger besteht ebenfalls vorzugsweise aus Kunststoff. Die in Fig. 3 gewählte schematische Darstellung soll keine einschränkende Wirkung, beispielsweise auf die Funktion des Befestigungsmechanismus, mit dem der Datenträger 34 an der Aufnahmeeinheit 32 befestigt wird, haben. Mit der Bezugsziffer 62 sind weitere Steckplätze, sogenannte Basismodule bezeichnet, über die beispielsweise weitere Spannungsversorgungs- oder Ein-/Ausgabemodule an die Sicherheitssteuereinheit 50 anschließbar sind.

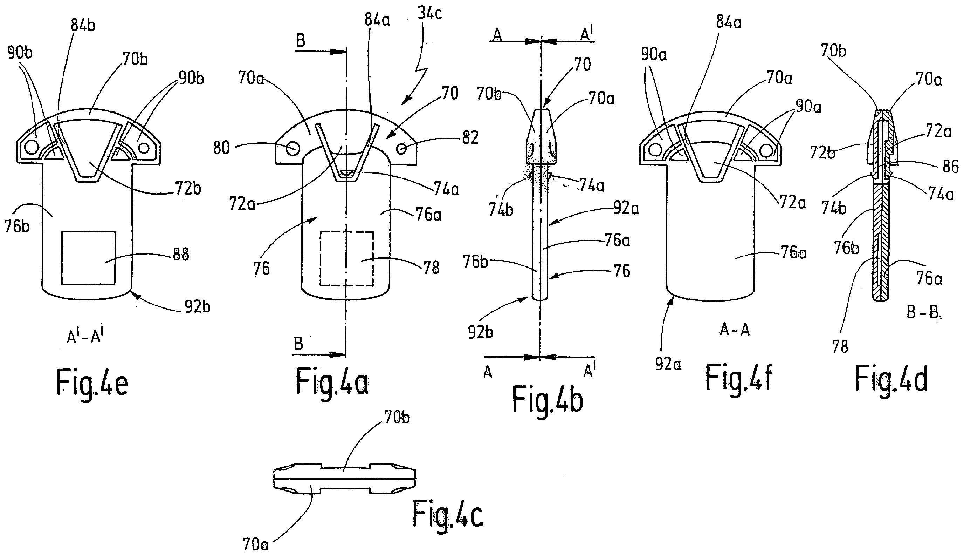

In Fig. 4, die aus den Teilfiguren 4a, 4b, 4c, 4d, 4e, 4f besteht, ist ein erstes Ausführungsbeispiel des erfindungsgemäßen Datenträgers anhand verschiedener Ansichten und Schnittdarstellungen gezeigt.

Teilfigur 4a zeigt in einer Draufsicht einen erfindungsgemäßen Datenträger 34c. Der Datenträger 34c weist einen Griff 70 auf, von dem in Teilfigur 4a ein Griffelement 70a dargestellt ist. An dem Griffelement 70a ist ein Befestigungselement 72a angebracht. Das Befestigungselement 72a weist eine Rastnase 74a auf. Der Datenträger 34c weist ferner ein Trägerelement 76 auf, von dem in Teilfigur 4a die in dieser Darstellung sichtbare Hälfte 76a dargestellt ist. In dem Trägerelement 76 ist ein Speicherelement 78 eingeschlossen. Bei dem Speicherelement 78 handelt es sich um einen Transponder zur berührungslosen Datenübertragung, beispielsweise einen sogenannten RFID-Transponder (RFID steht für *radio frequency identification*). Der Griff 70 weist Durchgangslöcher 80, 82 auf, mit deren Hilfe der Datenträger 34c bei Bedarf zusätzlich an dem Gehäuse der Sicherheitssteuerung beispielsweise mit Hilfe eines Kabelbinders oder einer Plombe befestigt werden kann. Außerdem kann der Datenträger 34c über die Durchgangslöcher 80, 82 im Transportfall, beispielsweise auf dem Weg zu der Sicherheitssteuerung, für die er verwendet werden soll, an einem Transportmittel befestigt werden. Die Durchgangslöcher 80,80 können dabei mit oder ohne Hülse ausgeführt sein. Das Griffelement 70a, das Befestigungselement 72a und das Trägerelement 76 sind so ausgebildet, dass das Befestigungselement 72a zu einem Großteil derart von einem durchgängigen Schlitz 84a umgeben ist, dass es an dem Griffelement 70a bewegbar angebracht ist. Somit ist das Befestigungselement 72a relativ zu dem Trägerelement 76 bewegbar.

Teilfigur 4b zeigt den Datenträger 34c in einer Seitenansicht. Der Datenträger 34c besteht aus zwei Schalenelementen 92a, 92b. Das Schalenelement 92a umfasst das Griffelement 70a und die Hälfte 76a des Trägerelements 76. Das Schalenelement 92b umfasst das Griffelement 70b und die Hälfte 76b des Trägerelements 76. Der Griff 70 besteht aus den beiden Griffelementen 70a, 70b.

In Teilfigur 4c ist der Datenträger 34c von oben dargestellt, wobei aufgrund der baulichen Ausgestaltung des Datenträgers in dieser Ansicht lediglich die beiden Griffelemente 70a, 70b zu sehen sind.

Teilfigur 4d zeigt eine Schnittdarstellung des Datenträgers 34c entlang der in Teilfigur 4a eingezeichneten Schnittlinie B-B. An dem Griffelement 70a ist das Befestigungselement 72a angebracht. An dem Griffelement 70b ist das Befestigungselement 72b angebracht. Das Befestigungselement 72a weist die Rastnase 74a auf. Das Befestigungselement 72b weist eine Rastnase 74b auf. Sowohl die beiden Griffelemente 70a, 70b als auch die beiden Befestigungselemente 72a, 72b sind konstruktiv so ausgebildet, dass zwischen den beiden Befestigungselementen 72a, 72b ein Hohlraum 86 entsteht. Dieser Hohlraum 86 geht in den in Teilfigur 4a dargestellten Schlitz 84a über. Aufgrund des Hohlraumes 86 können die beiden Befestigungselemente 72a, 72b unter Aufbringung einer entsprechenden Kraft gegeneinander bewegt werden. Der Transponder 78 ist vollständig in die Hälfte 76b des Trägerelementes 76 eingelassen.

Teilfigur 4e zeigt in einer Draufsicht ein Schalenelement 92b des Datenträgers 34c. Diese Draufsicht entspricht dem Blick aus Richtung A' auf den aufgeschnittenen Datenträger 34c, wenn dieser entlang der in Teilfigur 4b eingezeichneten Schnittlinie aufgeschnitten ist. Das Schalenelement 92b weist das Griffelement 70b, das Befestigungselement 72b sowie eine Hälfte 76b des Trägerelements 76 auf. Das Befestigungselement 72b ist von einem durchgängigen Schlitz 84b umgegeben, der ebenfalls in den Hohlraum 86 übergeht. In der Hälfte 76b ist eine Aussparung 88 eingelassen, die der Aufnahme des Transponders 78 dient. Das Schalenelement 92b weist im Bereich des Griffelementes 70b Vertiefungen 90b auf.

Teilfigur 4f zeigt in einer Draufsicht ein Schalenelement 92a des Datenträgers 34c. Diese Draufsicht entspricht dem Blick aus Richtung A auf den aufgeschnittenen Datenträger 34c, wenn dieser entlang der in Teilfigur 4b eingezeichneten Schnittlinie aufgeschnitten ist. Das Schalenelement 92a besteht aus dem Griffelement 70a, dem Befestigungselement 72a und der Hälfte 76a des Trägerelementes 76. Das Schalenelement 92a weist im Bereich des Griffelementes 70a Vertiefungen 90a auf. Das Befestigungselement 72a ist von dem durchgängigen Schlitz 84a umgegeben. Sind die beiden Schalenelemente 92a, 92b zusammengefügt, so bilden sich durch die Vertiefungen 90a, 90b Hohlräume aus. Insgesamt wird so weniger Material bei der Herstellung des Datenträgers 34c benötigt.

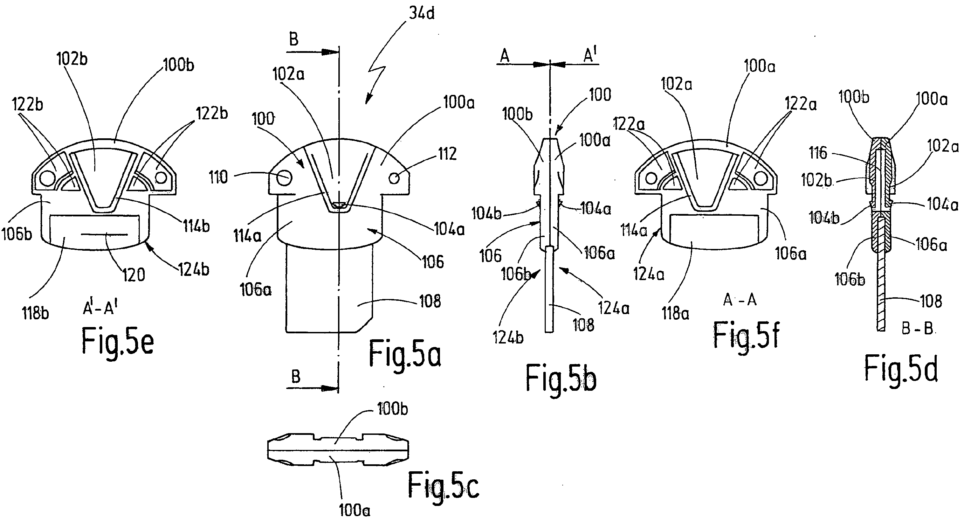

In Fig. 5, die aus den Teilfiguren 5a, 5b, 5c, 5d, 5e, 5f besteht, ist ein zweites Ausführungsbeispiel des erfindungsgemäßen Datenträgers anhand verschiedener Ansichten und Schnittdarstellungen gezeigt.

Teilfigur 5a zeigt in einer Draufsicht einen erfindungsgemäßen Datenträger 34d. Der Datenträger 34d weist einen Griff 100 auf, von dem in Teilfigur 5a ein Griffelement 100a dargestellt ist. An dem Griffelement 100a ist ein Befestigungselement 102a angebracht. Das Befestigungselement 102a weist eine Rastnase 104a auf. Ferner weist der Datenträger 34d ein Trägerelement 106 auf, von dem in Teilfigur 5a die in dieser Darstellung sichtbare Hälfte 106a dargestellt ist. Das Trägerelement 106 trägt ein Speicherelement 108. Bei dem Speicherelement handelt es sich um eine handelsübliche Speicherkarte, beispielsweise eine SD-Karte. Das Griffelement 100a, das Befestigungselement 102a und das Trägerelement 106 sind derart konstruktiv ausgebildet, dass das Befestigungselementes 102a zu einem Großteil von einem durchgängigen Schlitz 114a umgeben ist. Somit ist auch bei dem Datenträger 34d das Befestigungselement 102a an dem Griffelement 100a bewegbar angebracht und lässt sich somit relativ zu dem Trägerelement 106 bewegen. Das Griffelement 100a weist Durchgangslöcher 110, 112 auf, die dieselbe Funktion erfüllen und denselben Aufbau haben, wie diejenigen des Datenträgers 34c.

Teilfigur 5b zeigt den Datenträger 34d in einer Seitenansicht. Der Datenträger 34d besteht aus zwei Schalenelementen 124a, 124b. Das Schalenelement 124a umfasst das Griffelement 100a und die Hälfte 106a des Trägerelements 106. Das Schalenelement 124b umfasst das Griffelement 100b und die Hälfte 106b des Trägerelements 106. Der Griff 100 aus den beiden Griffelementen 100a, 100b. Die Speicherkarte 108 wird von dem Trägerelement 106 gehalten.

Teilfigur 5c zeigt den Datenträger 34d in einer Ansicht von oben. Aufgrund der konstruktiven Ausgestaltung des Datenträgers sind in dieser Ansicht lediglich die beiden Griffelemente 100a, 100b zu sehen.

Teilfigur 5d zeigt eine Schnittdarstellung des Datenträgers 34d entlang der in Teilfigur 5a eingezeichneten Schnittlinie B-B. An dem Griffelement 100a ist das Befestigungselement 102a angebracht. An dem Griffelement 100b ist das Befestigungselement 102b angebracht. Das Befestigungselement 102a weist die Rastnase 104a auf. Das Befestigungselement 102b weist die Rastnase 104b auf. Sowohl die beiden Griffelemente 100a, 100b als auch die beiden Befestigungselemente 102a, 102b sind konstruktiv so ausgestaltet, dass sich zwischen den beiden Befestigungselementen 102a, 102b ein Hohlraum 116 ausbildet. Dieser Hohlraum 116 geht in den in Teilfigur 5a dargestellten Schlitz 114a über. Aufgrund des Hohlraums 116 lassen sich die beiden Befestigungselemente 102a, 102b bei Aufbringung einer entsprechenden Kraft gegeneinander bewegen. Die Speicherkarte 108 ist teilweise von den beiden Hälften 106a, 106b des Trägerelementes 106 umfasst.

Teilfigur 5e zeigt in einer Draufsicht ein Schalenelement 124b des Datenträgers 34d. Diese Draufsicht entspricht dem Blick aus Richtung A' aus den aufgeschnittenen Datenträger 34d, wenn dieser entlang der in Teilfigur 5b eingezeichneten Schnittlinie aufgeschnitten ist. Das Schalenelement 124b besteht aus dem Griffelement 100b, dem Befestigungselement 102b und der Hälfte 106b des Trägerelementes 106. Die Hälfte 106b des Trägerelementes 106 weist eine Aussparung 118b auf, die der Aufnahme der Speicherkarte 108 dient. In die Aussparung 118d ist eine linienförmige Erhebung 120 eingelassen, die in eine Nut der Speicherkarte 108 eingreift. Dadurch ist eine stabile Befestigung der in das Trägerelement 106 einschiebbaren Speicherkarte 108 im Trägerelement 106 gewährleistet. Im Bereich des Griffelementes 100b sind Vertiefungen 122b angeordnet. Das Befestigungselement 102b ist von einem durchgängigen Schlitz 114b umgeben, der ebenfalls in den Hohlraum 116 übergeht. Der Schlitz 114b entspricht hinsichtlich seiner Funktionalität dem Schlitz 114a.

Teilfigur 5f zeigt in einer Draufsicht ein Schalenelement 124a des Datenträgers 34d. Diese Draufsicht entspricht dem Blick aus Richtung A auf den aufgeschnittenen Datenträger 34d, wenn dieser entlang der in Teilfigur 5b eingezeichneten Schnittlinie aufgeschnitten ist. Das Schalenelement 124a besteht aus dem Griffelement 100a, dem Befestigungselement 102a und der Hälfte 106a des Trägerelementes 106. Das Befestigungselement 102a ist von dem Spalt 114a umgeben. Das Trägerelement 106a weist eine Aussparung 118a auf, die der Aufnahme der Speicherkarte 108 dient. Im Bereich des Griffelementes 100a sind Vertiefungen 122a eingelassen. Sind die beiden Schalenelemente 124a, 124b zusammengefügt, so bilden sich durch die Vertiefungen 122a, 122b Hohlräume aus. Insgesamt wird so weniger Material bei der Herstellung des Datenträgers 34d benötigt.

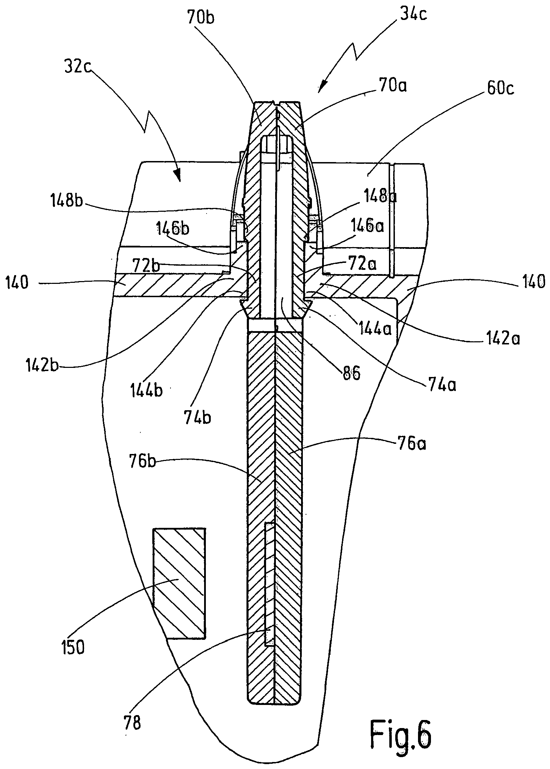

Fig. 6 zeigt in einer Schnittdarstellung den in einer Aufnahmeeinheit 32c befestigten Datenträger 34c. Die Aufnahmeeinheit 32c ist Teil eines Gehäuse 60c der Sicherheitssteuerung 1 bzw. einer Teilkomponente 10, 10a, 10b der Sicherheitssteuerung 1. Die Aufnahmeeinheit 32c besteht aus zwei in die Gehäusewand 140 eingearbeiteten Halteelementen 142a, 142b. Die beiden Halteelemente 142a, 142b sind so zueinander beabstandet angeordnet, dass in der Gehäusewand 140 eine Öffnung entsteht, durch die der Datenträger 34c eingeführt werden kann. Das Halteelement 142a weist eine Rastkante 144a und eine von dieser beabstandete Haltekante 146a auf. Das Halteelement 142b weist eine Rastkante 144b und eine von dieser beabstandete Haltekante 146b auf. Das Befestigungselement 72a des Datenträgers 34c weist die bereits beschriebene Rastnase 74a und eine von dieser beabstandete Sicherungskante 148a auf. Das Befestigungselement 72b weist die bereits beschriebene Rastnase 74b und eine von dieser beabstandete Sicherungskante 148b auf. Die beiden Befestigungselemente 72a, 72b und die beiden Halteelemente 142a, 142b bilden eine Rastvorrichtung. Ist der Datenträger 34c vollständig in die Aufnahmeeinheit 32c eingefügt, so hintergreift die Rastnase 74a die Rastkante 144a und die Rastnase 74b hintergreift die Rastkante 144b. Zudem liegt die Sicherungskante 148a liegt auf der Haltekante 146a auf und die Sicherungskante 148b liegt auf der Haltekante 146b auf. Somit entsteht eine formschlüssige Verbindung, über die der Datenträger 34c an der Aufnahmeeinheit 32c befestigt ist. Durch eine entsprechend enge Beabstandung der beiden Halteelemente 142a, 142b kann erreicht werden, dass bei vollständig in die Aufnahmeeinheit 32c eingeführtem Datenträger 34c, die Befestigungselemente 72a, 72b unter Vorspannung von den Haltelementen 142a, 142b gehalten werden. In diesem Fall wird der Datenträger 34c von der Aufnahmeeinheit 32c aufgrund einer formschlüssigen Verbindung und einer kraftschlüssigen Verbindung gehalten.

Wie der Darstellung in Fig. 6 zu entnehmen ist, weisen die Rastnasen 74a, 74b ein angeschrägtes Profil auf. Dies führt dazu, dass die Rastvorrichtung beim Einführen des Datenträgers 34c in die Aufnahmeeinheit 32c selbsttätig rastet. Wohingegen beim Entfernen des Datenträgers 34c zunächst durch Zusammendrücken der beiden Befestigungselemente 72a, 72b die Rastvorrichtung entrastet werden muss. Vorzugsweise ist das angeschrägte Profil, wie dargestellt, dreieckförmig ausgebildet. Alternativ zu dem angeschrägten Profil können die beiden Rastnasen 74a, 74b auch solch ein Profil aufweisen, bei dem die Berandungslinie parallel zu den Längsachsen der beiden Hälften 76a, 76b des Trägerelementes 76 verläufen. In diesem Fall handelt es sich um ein rechteckförmiges Profil. Dieses rechteckförmige Profil führt dazu, dass beim Einführen des Datenträgers 34c in die Aufnahmeeinheit 32c zunächst die beiden Befestigungselemente 72a, 72b zusammengedrückt werden müssen, damit der Datenträger überhaupt in die Aufnahmeeinheit eingeführt werden kann.

Wie der Darstellung in Fig. 6 ferner zu entnehmen ist, sind das Befestigungselement 72a und das Griffelement 70a einstückig ausgeführt. Ebenso sind das Befestigungselement 72b und das Griffelement 70b einstückig ausgeführt. Dies führt dazu, dass ein die Funktion der Rastvorrichtung beeinträchtigendes Spiel auf ein Mindestmaß reduziert wird. Alternativ zu der einstückigen Ausführung können die Befestigungselemente 72a, 72b auch lösbar an dem entsprechenden Griffelement 70a, 70b angebracht sein. In diesem Fall sind zwar zusätzliche Maßnahmen erforderlich, um ein die Funktion der Rastvorrichtung beeinträchtigendes Spiel zu reduzieren. Vorteilhaft ist allerdings, dass in ihrer Funktion nachlassende Befestigungselemente bei Bedarf ausgetauscht werden können.

Mit Bezugsziffer 150 ist eine Übertragungseinheit bezeichnet, mit der berührungslos auf dem Transponder 78 gespeicherte Daten empfangen und Daten auf den Transponder 78 übertragen werden können. Die Übertragungseinheit 150 kann Teil einer Ein-/Ausgabeeinheit 18, 18a, 18b sein. Es kann sich aber auch um eine eigenständige, der Ein-/Ausgabeeinheit 18, 18a, 18b vorgeschaltete Einheit handeln.

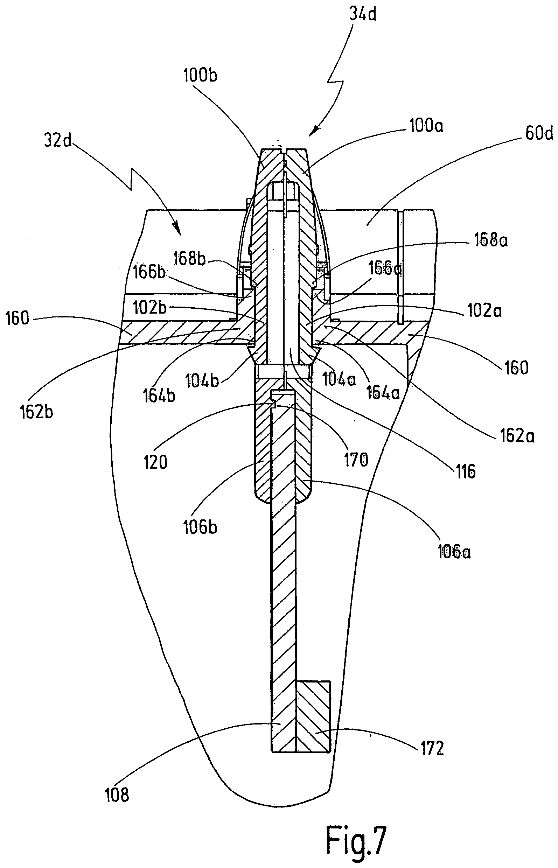

In Fig. 7 ist in einer Schnittdarstellung der in einer Aufnahmeeinheit 32d befestigte Datenträger 34d dargestellt. Die Aufnahmeeinheit 32d ist Teil eines Gehäuses 60d der Sicherheitssteuerung 1 oder einer Teilkomponente 10, 10a, 10b der Sicherheitssteuerung 1. Die Aufnahmeeinheit 32d aus zwei in die Gehäusewand 160 eingearbeitete Halteelementen 162a und 162b aufgebaut. Die beiden Halteelemente 162a, 162b sind dabei so zueinander beabstandet, dass eine Öffnung entsteht, in die der Datenträger 34d eingeführt werden kann. Das Halteelement 162a weist eine Rastkante 164a und eine von dieser beabstandete Haltekante 166a auf. Das Halteelement 162b weist eine Rastkante 164b und eine von dieser beabstandete Haltekante 166b auf. Das Befestigungselement 102a weist die bereits beschriebene Rastnase 104a und eine von dieser beabstandete Sicherungskante 168a auf. Das Befestigungselement 102b weist die bereits beschriebene Rastnase 104b und eine von dieser beabstandete Sicherungskante 168b auf. Durch die beiden Befestigungselemente 102a, 102b und die mit diesen zusammenwirkenden Halteelemente 162a, 162b wird eine Rastvorrichtung gebildet. Ist der Datenträger 34d vollständig in die Aufnahmeeinheit 32d eingeführt, hintergreift die Rastnase 104a die Rastkante 164a und die Rastnase 104b hintergreift die Rastkante 164b. Zudem liegt die Sicherungskante 168a auf der Haltekante 166a und die Sicherungskante 168b auf der Haltekante 166b auf. Dadurch entsteht eine formschlüssige Verbindung, durch die der Datenträger 34d an der Aufnahmeeinheit 32d befestigt ist. Hinsichtlich der Kombination der formschlüssigen Verbindung mit einer kraftschlüssigen Verbindung wird auf die im Zusammenhang mit der Figur 6 gemachten Ausführungen verwiesen.

Die beiden Rastnasen 104a, 104b weisen das bereits im Zusammenhang mit der Fig. 6 beschriebene angeschrägte Profil auf. Auch für den Datenträger 34d ist es denkbar, dass die beiden Rastnasen 104a, 104b das im Zusammenhang mit der Fig. 6 bereits beschriebene rechteckförmige Profil aufweisen können. Auf die im Zusammenhang mit der Figur 6 gemachten Ausführungen zu den beiden Profilen wird verwiesen.

Die Hälfte 106b des Trägerelementes 106 weist die bereits im Zusammenhang mit der Teilfigur 5e beschriebene linienförmige Erhebung 120 auf, die in eine Nut 170 der Speicherkarte 108 eingreift. Bei diesem Ausführungsbeispiel übernimmt die Speicherkarte 108 beim Einführen des Datenträgers 34d in die Aufnahmeeinheit 32d die Funktion des Zentrierens, die ansonsten vom Trägerelement übernommen wird.

Mit Bezugsziffer 172 ist eine elektrische Kontakte aufweisende Kontaktiereinheit bezeichnet. Im vollständig eingeführten Zustand des Datenträgers 34d in die Aufnahmeeinheit 32d, die Rastvorrichtung ist eingerastet, berühren auf der Speicherkarte 108 angeordnete Kontakte die Kontakte der Kontaktiereinheit 172. Somit entsteht eine elektrisch leitfähige Verbindung und es können die auf der Speicherkarte 108 abgelegten Daten ausgelesen werden. Ebenso können Daten von der Sicherheitssteuerung 1 oder einer Teilkomponente 10, 10a, 10b der Sicherheitssteuerung 1 auf die Speicherkarte 108 übertragen werden. Die Kontaktiereinheit 172 kann Teil einer Ein-/Ausgabeeinheit 18, 18a, 18b sein. Es kann sich aber auch um eine eigenständige, der Ein-/Ausgabeeinheit 18, 18a, 18b vorgeschaltete Einheit handeln.

## Patentansprüche

1. Sicherheitssteuerung zum Steuern von Maschinen oder Anlagen (52), von denen im Betrieb eine Gefahr für Menschen oder materielle Güter ausgeht, mit einer Ein-/Ausgabeeinheit (18) zum Aufnahmen von Eingangssignalen (20) von externen Sensoren (22) und zum Ausgeben von Ausgangssignalen (24) an externe Aktuatoren (26), mit einer Aufnahmeeinheit (32) für einen Datenträger, mit einem Datenträger (34, 34a, 34b, 34c, 34d, 34e, 34f) mit einem Trägerelement (76, 106, 182, 192), welches ein Speicherelement (78, 108, 184, 194) trägt, wobei in dem Speicherelement (78, 108, 184, 194) Daten (36, 38) für die Sicherheitssteuerung (1) abgelegt sind, wobei das Speicherelement ein Transponder (78, 184) zur berührungslosen Datenübertragung oder eine Speicherkarte (108, 194) mit Kontakten ist, und mit einer Übertragungseinheit (150) zum berührungslosen Datenaustausch mit dem Transponder (78, 184) oder einer Kontaktiereinheit (172) zum Kontaktieren der Kontakte auf der Speicherkarte (108, 194), **dadurch gekennzeichnet, dass** der Datenträger (34, 34a, 34b, 34c, 34d, 34e, 34f) zumindest ein Befestigungselement (72a, 72b, 102a, 102b, 186a, 186b, 196a, 196b) aufweist, welches derart relativ zu dem Trägerelement (76, 106, 182, 192) bewegbar ist, dass es dadurch mit der Aufnahmeeinheit (32, 32a, 32b, 32c, 32d, 32e, 32f) zusammenwirken kann, wodurch der Datenträger (34, 34a, 34b, 34c, 34d, 34e, 34f) an der Aufnahmeeinheit (32, 32a, 32b, 32c, 32d, 32e, 32f) befestigt wird, wobei die Aufnahmeeinheit (32c, 32d) zumindest ein Halteelement (142a, 142,b, 162a, 162b) aufweist, wobei das Befestigungselement (72a, 72b, 102a, 102b) und das Halteelement (142a, 142,b, 162a, 162b) derart ausgebildet sind, dass der Datenträger (34c, 34d) zumindest durch eine sich zwischen dem Befestigungselement (72a, 72b, 102a, 102b) und dem Halteelement (142a, 142,b, 162a, 162b) einstellende formschlüssige Verbindung an der Aufnahmeeinheit (32c, 32d) befestigt wird, und wobei das Befestigungselement (72a, 72b, 102a, 102b) eine Rastnase (74a, 74b, 104a, 104b) und eine von dieser beabstandete Sicherungskante (148a, 148b, 168a, 168b) aufweist, und dass das Halteelement (142a, 142b, 162a, 162b) eine Rastkante (144a, 144b, 164a, 164b) und eine von dieser beabstandete Haltekante (146a, 146b, 166a, 166b) aufweist, wobei die formschlüssige Verbindung dadurch entsteht, dass die Rastnase (74a, 74b, 104a, 104b) die Rastkante (144a, 144b, 164a, 164b) hintergreift und die Sicherungskante (148a, 148b, 168a, 168b) auf der Haltekante (146a, 146b, 166a, 166b) aufliegt.

2. Sicherheitssteuerung nach Anspruch 1, **dadurch gekennzeichnet, dass** die in dem Speicherelement (78, 108, 184, 194) abgelegten Daten (36, 38) einen Zustand und/oder eine Eigenschaft der Sicherheitssteuerung oder zumindest einer Teilkomponente (10, 10a, 10b) der Sicherheitssteuerung beschreiben oder beeinflussen.

3. Sicherheitssteuerung nach Anspruch 1 oder 2, **dadurch gekennzeichnet, dass** das Befestigungselement (72a, 72b, 102a, 102b) und die Aufnahmeeinheit (32, 32a, 32b, 32c, 32d) derart zusammenwirken, dass eine selbsthemmende Verbindung entsteht.

4. Sicherheitssteuerung nach einem der Ansprüche 1 bis 3, **dadurch gekennzeichnet, dass** die Aufnahmeeinheit (32, 32a, 32b, 32c, 32d) derart schachtförmig ausgebildet ist, dass der Datenträger (34, 34a, 34b, 34c, 34d) zumindest mit seinem Trägerelement (76, 106, 182, 192) in die Aufnahmeeinheit (32, 32a, 32b, 32c, 32d) eingeführt werden kann.

5. Sicherheitssteuerung nach einem der Ansprüche 1 bis 4, **dadurch gekennzeichnet, dass** die Rastnase (74a, 74b, 104a, 104b) derart ausgebildet ist, dass sich das Befestigungselement (72a, 72b, 102a, 102b) beim Einführen des Trägerelements (76, 106) in die Aufnahmeeinheit (32c, 32d) von dem Halteelement (142a, 142b, 162a, 162b) wegbewegt, sobald die Rastnase (74a, 74b, 104a, 104b) an dem Halteelement (142a, 142b, 162a, 162b) anliegt, und sich das Befestigungselement (72a, 72b, 102a, 102b) zurückbewegt und eine Ruheposition einnimmt, sobald die Rastnase (74a, 74b, 104a, 104b) unter Beibehaltung der Einführbewegung das Haltelement (142a, 142b, 162a, 162b) passiert hat.

6. Sicherheitssteuerung nach einem der Ansprüche 1 bis 5, **dadurch gekennzeichnet, dass** der Datenträger (34c, 34d) ein Griffelement (70a, 70b, 100a, 100b) aufweist, an dem das Befestigungselement (72a, 72b, 102a, 102b) bewegbar angebracht ist.

7. Sicherheitssteuerung nach Anspruch 6, **dadurch gekennzeichnet, dass** das Griffelement (70a, 70b, 100a, 100b) und das Befestigungselement (72a, 72b, 102a, 102b) einstückig miteinander verbunden sind.

8. Sicherheitssteuerung nach einem der Ansprüche 1 bis 7, **dadurch gekennzeichnet, dass** der Datenträger (34c, 34d) zwei Befestigungselemente (72a, 72b, 102a, 102b) aufweist.

## Claims

1. A safety controller for controlling machines or installations (52), which present a hazard to humans or material goods during operation, comprising an input/output unit (18) for receiving input signals (20) from external sensors (22) and for producing output signals (24) to external actuators (26), comprising a holding unit (32) for a data storage medium, comprising a data storage medium (34, 34a, 34b, 34c, 34d, 34e, 34f) having a carrier element (76, 106, 182, 192) which carries a memory element (78, 108, 184, 194), wherein the memory element (78, 108, 184, 194) stores data (36, 38) for the safety controller, wherein the memory element is a transponder (78, 184) for a non-contact data transfer or a memory card (108, 194) having contacts, and comprising a transfer unit (150) for non-contact data exchange with the transponder (78, 184) or a contact-connection unit (172) for contacting the contacts of the memory card (108, 194), **characterized in that** the data storage medium (34, 34a, 34b, 34c, 34d, 34e, 34f) has at least one mounting element (72a, 72b, 102a, 102b, 186a, 186b, 196a, 196b) which is able to move relative to the carrier element (76, 106, 182, 192) such that it is able to interact with the holding unit (32, 32a, 32b, 32c, 32d, 32e, 32f), as a result of which the data storage medium (34, 34a, 34b, 34c, 34d, 34e, 34f) is mounted on the holding unit (32, 32a, 32b, 32c, 23d, 32e, 32f), wherein the holding unit (32c, 32d) has at least one retaining element (142a, 142b, 162a, 162b), wherein the mounting element (72a, 72b, 102a, 102b) and the retaining element (142a, 142b, 162a, 162b) are in a form such that the data storage medium (34c, 34d) is mounted on the holding unit (32c, 32d) at least by a form-fit connection which is produced between the mounting element (72a, 72b, 102a, 102b) and the retaining element (142a, 142b, 162a, 162b), and wherein the mounting element (72a, 72b, 102a, 102b) has a latching lug (74a, 74b, 104a, 104b) and a securing edge (148a, 148b, 168a, 168b) at a distance therefrom, and the retaining element (142a, 142b, 162a, 162b) has a latching edge (144a, 144b, 164a, 164b) and a retaining edge (146a, 146b, 166a, 166b) at a distance therefrom, wherein the form-fit connection is produced by virtue of the latching lug (74a, 74b, 104a, 104b) engaging behind the latching edge (144a, 144b, 164a, 164b) and the securing edge (148a, 148b, 168a, 168b) being supported on the retaining edge (146a, 146b, 166a, 166b).

2. The safety controller of claim 1, **characterized in that** the data (36, 38) stored in the memory element (78, 108, 184, 194) describe or affect a state and/or a property of the safety controller or of at least one subcomponent (10, 10a, 10b) of the safety controller.

3. The safety controller of claim 1 or 2, **characterized in that** the mounting element (72a, 72b, 102a, 102b) and the holding unit (32, 32a, 32b, 32c, 32d) interact such that a self-locking connection is produced.

4. The safety controller of one of claims 1 to 3, **characterized in that** the holding unit (32, 32a, 32b, 32c, 32d) is in the form of a recess such that the data storage medium (34, 34a, 34b, 34c, 34d) can be introduced into the holding unit (32, 32a, 32b, 32c, 32d), at least with its carrier element (76, 106, 182, 192)

5. The safety controller of one of claims 1 to 4, **characterized in that** the latching lug (74a, 74b, 104a, 104b) is in a form such that the mounting element (72a, 72b, 102a, 102b) moves away from the retaining element (142a, 142b, 162a, 162b) arranged in the holding unit (32c, 32d) when the carrier element (76, 106) is introduced into the holding unit (32c, 32d) as soon as the latching lug (74a, 74b, 104a, 104b) abuts the retaining element (142a, 142b, 162a, 162b), and the mounting element (72a, 72b, 102a, 102b) moves back and adopts a position of rest as soon as the latching lug (74a, 74b, 104a, 104b) has passed the retaining element (142a, 142b, 162a, 162b) while maintaining the introduction movement.

6. The safety controller of one of claims 1 to 5, **characterized in that** the data storage medium (34c, 34d) has a grip element (70a, 70b, 100a, 100b) to which the mounting element (72a, 72b, 102a, 102b) is moveably connected.

7. The safety controller of claim 6, **characterized in that** the grip element (70a, 70b, 100a, 100b) and the mounting element (72a, 72b, 102a, 102b) are integrally connected to one another.

8. The safety controller of one of claims 1 to 7, **characterized in that** the data storage medium (34c, 34d) has two mounting elements (72a, 72b, 102a, 102b).

## Revendications

1. Commande de sécurité destinée à commander des machines ou des installations (52) desquelles, en fonctionnement, émane un risque pour les humains ou les biens matériels, comprenant une unité d'entrée/sortie (18) destinée à collecter des signaux d'entrée (20) en provenance de capteurs externes (22) et à délivrer des signaux de sortie (24) vers des actionneurs externes (26), comprenant une unité d'enregistrement (32) pour un support de données, comprenant un support de données (34, 34a, 34b, 34c, 34d, 34e, 34f), comprenant un élément porteur (76, 106, 182, 192) qui porte un élément de mémoire (78, 108, 184, 194), des données (36, 38) pour la commande de sécurité (1) étant stockées dans l'élément de mémoire (78, 108, 184, 194), l'élément de mémoire étant un transpondeur (78, 184) destiné à la transmission de données sans contact ou une carte de mémoire (108, 194) munie de contacts, et comprenant une unité de transmission (150) destinée à l'échange de données sans contact avec le transpondeur (78, 184) et une unité d'établissement de contact (172) destinée à établir le contact avec les contacts sur la carte de mémoire (108, 194), **caractérisée en ce que** le support de données (34, 34a, 34b, 34c, 34d, 34e, 34f) possède au moins un élément de fixation (72a, 72b, 102a, 102b, 186a, 186b, 196a, 196b) qui peut être déplacé par rapport à l'élément porteur (76, 106, 182, 192) de telle sorte qu'il peut coopérer avec l'unité d'enregistrement (32, 32a, 32b, 32c, 32d, 32e, 32f), ce par quoi le support de données (34, 34a, 34b, 34c, 34d, 34e, 34f) est fixé à l'unité d'enregistrement (32, 32a, 32b, 32c, 32d, 32e, 32f), l'unité d'enregistrement (32c, 32d) possédant au moins un élément de maintien (142a, 142,b, 162a, 162b), l'élément de fixation (72a, 72b, 102a, 102b) et l'élément de maintien (142a, 142,b, 162a, 162b) étant configurés de telle sorte que le support de données (34c, 34d) est fixé à l'unité d'enregistrement (32c, 32d) au moins par une liaison par complémentarité de formes qui s'établit entre l'élément de fixation (72a, 72b, 102a, 102b) et l'élément de maintien (142a, 142,b, 162a, 162b), et l'élément de fixation (72a, 72b, 102a, 102b) possédant un tenon d'enclenchement (74a, 74b, 104a, 104b) et une arête de blocage (148a, 148b, 168a, 168b) espacée de celui-ci, et **en ce que** l'élément de maintien (142a, 142b, 162a, 162b) possède une arête d'enclenchement (144a, 144b, 164a, 164b) et une arête de maintien (146a, 146b, 166a, 166b) espacée de celle-ci, la liaison par complémentarité de formes étant établie **en ce que** le tenon d'enclenchement (74a, 74b, 104a, 104b) vient en prise par l'arrière avec l'arête d'enclenchement (144a, 144b, 164a, 164b) et l'arête de blocage (148a, 148b, 168a, 168b) repose sur l'arête de maintien (146a, 146b, 166a, 166b).

2. Commande de sécurité selon la revendication 1, **caractérisée en ce que** les données (36, 38) stockées dans l'élément de mémoire (78, 108, 184, 194) décrivent ou influencent un état et/ou une propriété de la commande de sécurité ou au moins d'un composant partiel (10, 10a, 10b) de la commande de sécurité.

3. Commande de sécurité selon la revendication 1 ou 2, **caractérisée en ce que** l'élément de fixation (72a, 72b, 102a, 102b) et l'unité d'enregistrement (32, 32a, 32b, 32c, 32d) coopèrent de telle sorte qu'il se produit une liaison autobloquante.

4. Commande de sécurité selon l'une des revendications 1 à 3, **caractérisée en ce que** l'unité d'enregistrement (32, 32a, 32b, 32c, 32d) est réalisée en forme de puits de telle sorte que le support de données (34, 34a, 34b, 34c, 34d) peut être introduit au moins avec son élément porteur (76, 106, 182, 192) dans l'unité d'enregistrement (32, 32a, 32b, 32c, 32d).

5. Commande de sécurité selon l'une des revendications 1 à 4, **caractérisée en ce que** le tenon d'enclenchement (74a, 74b, 104a, 104b) est configuré de telle sorte que lors de l'introduction de l'élément porteur (76, 106) dans l'unité d'enregistrement (32c, 32d), l'élément de fixation (72a, 72b, 102a, 102b) s'éloigne de l'élément de maintien (142a, 142b, 162a, 162b) dès que le tenon d'enclenchement (74a, 74b, 104a, 104b) repose contre l'élément de maintien (142a, 142b, 162a, 162b) et l'élément de fixation (72a, 72b, 102a, 102b) se déplace en sens inverse et adopte une position de repos dès que le tenon d'enclenchement (74a, 74b, 104a, 104b) a dépassé l'élément de maintien (142a, 142b, 162a, 162b) en maintenant le mouvement d'introduction.

6. Commande de sécurité selon l'une des revendications 1 à 5, **caractérisée en ce que** le support de données (34c, 34d) possède un élément de préhension (70a, 70b, 100a, 100b) sur lequel l'élément de fixation (72a, 72b, 102a, 102b) est monté mobile.

7. Commande de sécurité selon la revendication 6, **caractérisée en ce que** l'élément de préhension (70a, 70b, 100a, 100b) et l'élément de fixation (72a, 72b, 102a, 102b) sont reliés l'un à l'autre d'un seul tenant.

8. Commande de sécurité selon l'une des revendications 1 à 7, **caractérisée en ce que** le support de données (34c, 34d) possède deux éléments de fixation (72a, 72b, 102a, 102b).
